Europäisches Patentamt

European Patent Office

Office européen des brevets

(11) Veröffentlichungsnummer: **0 332 567**
**A1**

(12) ## EUROPÄISCHE PATENTANMELDUNG

(21) Anmeldenummer: **89710007.9**

(22) Anmeldetag: **02.02.89**

(51) Int. Cl.⁴: **H 05 K 3/34**

(30) Priorität: **11.03.88 DE 3808073**

(43) Veröffentlichungstag der Anmeldung:
**13.09.89 Patentblatt 89/37**

(84) Benannte Vertragsstaaten:
**AT BE CH DE ES FR GB GR IT LI LU NL SE**

(71) Anmelder: **Himmelreich, Lothar**
**Grenzstrasse 7**
**D-6380 Bad Homburg v.d.H. (DE)**

(72) Erfinder: **Himmelreich, Lothar**
**Grenzstrasse 7**
**D-6380 Bad Homburg v.d.H. (DE)**

(74) Vertreter: **Schubert, Siegmar, Dipl.-Ing. et al**
**Patentanwälte Dr. V. Schmied-Kowarzik Dr. P. Weinhold**
**Dr.-Ing. G. Dannenberg Dr. D. Gudel Dipl.-Ing. S. Schubert**
**Dr. P. Barz Grosse Eschenheimer Strasse 39**
**D-6000 Frankfurt am Main 1 (DE)**

(54) **Infrarot-Lötofen zum Aufschmelzlöten von elektronischen Bauelementen auf Leiterplatten.**

(57) Ein Infrarot-Lötofen zum Aufschmelzlöten (Reflowlöten) von elektronischen Bauelementen auf Leiterplatten mittels einer Lotpaste umfaßt einen Heizraum, der mit einem im wesentlichen vertikalen Luftstrom belüftet ist und in dem die Leiterplatten auf einem für Infrarot-Strahlung und für den Luftstrom zumindest teilweise durchlässigen Träger (37) auflie- gen. Über und unter dem Träger sind Infrarot-Strahler (39 - 42) angeordnet, welche die mit den Bauelementen bestückten und mit der Lotpaste versehenen Leiterplatten während einer Aufheizphase und einer Schmelzphase mit unterschiedlichen Temperaturen beheizen. Zum gleichmäßigen Aufheizen der Leiterplatten weist der für die Infrarot-Strahlung durchlässige Träger (34, 35, 37) eine für den Luftstrom undurchlässige, jedoch für die Infrarot-Strahlung durchlässige flache Luftsperre (46) als Auflage der Leiterplatten (z.B 38) auf. Die Luftsperre (46) überragt die aufgelegten Leiterplatten seitlich vollständig, ist jedoch im Abstand (48, 49) gegenüber den Heizraum begrenzenden Wänden (7, 8) angeordnet. Damit begrenzt sie mindestens einen Spalt (Spaltbreiten 48, 49) für den vertikalen Luftstrom. Für Lötungen in Schutzgasatmosphäre ist in dem Heizraum eine kleinere Kammer (53) angeordnet.

Fig.1

**Beschreibung**

## Infrarot-Lötofen zum Aufschmelzlöten von elektronischen Bauelementen auf Leiterplatten

Die Erfindung betrifft einen Infrarot-Lötofen zum Aufschmelzlöten von elektronischen Bauelementen auf Leiterplatten nach dem Oberbegriff des Anspruchs 1.

Bei dem Aufschmelzlöten werden elektronische Bauelemente, insbesondere sogenannte OMB mit Anschlußleitern, wie Quad Packages und Chip Carriers auf Leiterplatten mittels Lotpasten aufgelötet. Die Leiterplatten bestehen dabei insbesondere aus Epoxydharz mit verzinnten Kupferbahnen. Auf den Leiterplatten wird eine Lotpaste durch Siebdruck, Maskendruck, Stempeldruck oder Dosierer aufgebracht. Anschließend werden die Bauelemente mit einem Kleber fixiert. Um die Bauelemente mittels der Lotpaste zu fügen, gehört das Infrarotlöten zum Stand der Technik. Bekannte Infrarot-Lötofen für diesen Zweck sind als Durchlaufofen mit einem endlos umlaufenden Träger insbesondere aus einem Gitter ausgebildet, auf dessen oberem Trum die bestückten Leiterplatten oder Substrate aufliegen. Auf dem Träger werden die bestückten Leiterplatten oder Substrate durch verschiedene Heizzonen, die in dem Infrarot-Lötofen vorgesehen sind, hindurchbewegt. Damit durchlaufen die Leiterplatten Zonen vorgegebener Temperaturen, die durch Infrarot-Strahler über und unter der Trägerbahn realisiert werden und ein Heizprofil bilden, welches - abgesehen von einem Vortrocknen der Lotpaste - eine Aufheizphase, eine Schmelzphase und eine Abkühlphase umfaßt. Die Lotpaste erfordert in einer Aufheizphase Temperaturen zwischen ca. $130 - 150°$ C. In der sich daran anschließenden Schmelzphase soll eine Temperatur von mindestens $20°$ C über der Schmelztemperatur des Lotes erreicht werden. Die Schmelzphase soll lange genug andauern (ca. 10 Sekunden), um eine ausreichende Benetzung und homogene Verteilung des Lotes zu ermöglichen. Üblich ist es zum Erreichen dieser Temperaturen, die Leiterplatten, die für Infrarot-Strahlung durchlässig sind, beidseitig zu bestrahlen. Anschließend sollen die heißen Lötstellen schnell abgekühlt werden. Während des vorangehenden Aufheizens und in der Schmelzphase soll eine ausreichende Absaugung vorhanden sein (Druckschrift der Firma DEMETRON "Lotpasten"; Prof. H.Müller "OMB/SMD Oberflächenmontierte Bauelemente in der Leiterplattentechnik", Saulgau 1986).

Durch die Absaugung sollen Lötdünste während des Lötvorgangs abgeführt werden. Hierzu werden generell die Leiterplatten in einem im wesentlichen vertikalen Luftstrom angeordnet, der im Falle einer Zwangsbelüftung, insbesondere durch Absaugen, die Konvektion unterstützt. Andererseits kühlt dieser Luftstrom die Leiterplatten in unerwünscht ungleichmäßiger Weise ab, nämlich in den Randbezirken der Leiterplatten erheblich stärker als in deren mittleren Bereich. Dies kann die Zuverlässigkeit der Aufschmelzlötung beeinträchtigen und/oder eine erhöhte Temperaturbelastung der Leiterplatten und der Bauelemente in dem mittleren Bereich der Leiterplatten bedingen, wenn deren Randbereiche mit Sicherheit stark genug durch die Infrarot-Strahlung erhitzt werden sollen.

Dieses Problem wird auch nicht durch eine Bauweise des Infrarot-Lötofens mit einem als Schieblade ausgebildeten Träger vollständig gelöst, der nur zum Einführen der bestückten Leiterplatten in den Infrarot-Lötofen in diesen einschiebbar und zum Kühlen und Entnehmen der Leiterplatten mit den aufgelöteten Bauelementen aus diesem herausschiebbar ist, jedoch im übrigen fixiert ist (Patentanmeldung P 37 15 940.2-34). Dabei sind Infrarot-Flächenstrahler parallel zu dem Träger mit einer Auflagefläche für die Leiterplatte so angeordnet, daß sie die Auflagefläche gleichmäßig aufheizen. Der Träger mit den bestückten Bauelementen befindet sich während der Aufheizphase und der Schmelzphase in einem Heizraum, der zugleich einen Abluftschacht bildet und in einen oberen Stutzen zum Abzug der Abluft übergeht. Der Abluftschacht wird insbesondere durch einen Querstromlüfter zwangsbelüftet. Die Zwangsbelüftung durch den Querstromlüfter unterstützt die Kaminwirkung in dem Abluftschacht. Im einzelnen weist bei diesem Infrarot-Lötofen der als Schieblade ausgebildete Träger einen horizontalen, im wesentlichen aus einem Drahtgitter bestehenden Teil als Auflagefläche der Leiterplatten zwischen einer vorderen wärmeisolierenden Schiebladenwand und einer hinteren Schiebladenwand auf.

Es könnte daran gedacht werden, den Effekt der unterschiedlich starken Abkühlung und damit ungleichmäßigen Aufheizung der bestückten Leiterplatten während der Aufheizphase und der Schmelzphase dadurch zu verringern, daß die Lötdünste mit vorgewärmter Luft abgeführt werden. Dies bedingt jedoch zur Vorwärmung der Luft einen größeren Energieeinsatz und kann die ungleichmäßige Abkühlung der Leiterplatten kaum in dem gewünschten Maße verhindern, da variable Temperaturunterschiede zwischen den einzelnen Zeitpunkten der Aufheizphase und der Schmelzphase an den Leiterplatten einerseits und der Warmluft andererseits bei vertretbarem Aufwand unvermeidlich sind.

Der Erfindung liegt daher die Aufgabe zugrunde, einen Infrarot-Lötofen der in dem Anspruch 1 bzw. Anspruch 3 angegebenen Gattung in der Hinsicht zu verbessern, daß sich die Flächen der bestückten Leiterplatten in dem Heizraum während der Aufheizphase und Schmelzphase trotz eines darin herrschenden vertikalen Luftstroms zur Abführung der Lötdünste gleichmäßig erwärmen. Die gleichmäßige Erwärmung soll sich auch bei einem hohen Luftdurchsatz infolge Zwangsbelüftung einstellen. Auf eine energiemäßig ungünstige Vorerwärmung der Luft soll verzichtet werden.

Diese Aufgabe wird erfindungsgemäß durch die im Prinzip gleiche Ausgestaltung der Infrarot-Lötofen nach den kennzeichnenden Teilen der Ansprüche 1 und 3 gelöst. Der Anspruch 1 geht dabei aus von einem Infrarot-Lötofen mit einem für Infrarot-Strahlung und für den Luftstrom zumindest teilweise durchlässigen Träger, wie er beispielsweise durch ein Gitter oder eine Anordnung paralleler Drähte realisiert sein kann. Der Anspruch 3 bezieht sich auf eine Variante des Infrarot-Lötofens, insbesondere als Durchlaufofen, dessen Träger zwar luftundurchlässig ist, aber bisher für Infrarot-Strahlung praktisch nicht durchlässig war. In diesem Fall war eine Anordnung der Infrarot-Strahler unter dem Träger nicht sinnvoll, was wiederum einem schnellen und gleichmäßigen Aufheizen der bestückten Leiterplatten auf dem Träger und dem schnellen und gleichmäßigen Schmelzen des Lots während der Schmelzphase abträglich sein konnte.

Das gemeinsame Prinzip der Erfindung besteht darin, daß durch die Verwendung einer für den Luftstrom undurchlässigen, jedoch für die Infrarot-Strahlung durchlässigen flachen Luftsperre als Auflage der Leiterplatten auf dem Träger, wobei die flache Auflage insbesondere eine Folie ist oder durch die Ausbildung des Trägers aus einer solchen Folie selbst zwar die bestückten Leiterplatten auch durch den Träger hindurch durch Infrarot-Strahlung erhitzt werden können, andererseits aber der im wesentlichen vertikale Luftstrom auch von den Randbereichen der Leiterplatten abgelenkt wird, so daß diese Randzonen im wesentlichen in der gleichen Weise erhitzt werden wie die weiter innen liegenden Bezirke der Leiterplatten. Wesentlich sind also die Eigenschaften des Materials, aus dem die zusätzliche Luftsperre als Auflage bzw. der Träger selbst besteht, während die mechanisch konstruktiven Maßnahmen verblüffend einfach und damit kostengünstig sind. Dies gilt insbesondere, wenn die flache Auflage nach Anspruch 2 aus einem Zuschnitt einer geeigneten Folie besteht, aber auch nach Anspruch 3, der einen Austausch des für den Luftstrom undurchlässigen Trägermaterials durch die Folie mit den angegebenen physikalischen Eigenschaften vorsieht.

Wesentlich ist außer den Stoff-Eigenschaften der Folie, für die nach Anspruch 7 eine Folie aus Polyimid ausgewählt ist, eine geringe Dicke dieser Folie nach Anspruch 8 von ca. 20 - 135 µm, mit der eine stärkere Infrarot-Absorption vermieden wird. Besonders günstig ist bei den Folien aus Polyimid für den vorliegenden Zweck insbesondere die geringe Absorption der Infrarot-Strahlung in einem für das Aufschmelzlöten wichtigen mittleren Infrarot-Wellenlängenbereich. Eine solche Folie aus reinem Polyimid ist unter dem Warenzeichen "KAPTON" im Handel erhältlich. Es ist bekannt, daß diese Polyimidfolie bei Temperaturen von -269° - +400° C eingesetzt werden kann, da sie schwer entflammbar und nicht schmelzend ist, wobei sie eine hohe Beständigkeit gegen energiereiche Strahlung aufweist.

Bei der Bemessung und Anordnung der flachen Auflage auf dem luftdurchlässigen Träger in der Bauweise nach dem Gattungsbegriff des Anspruchs 1 bzw. bei der Ausbildung des Trägers aus solcher Folie bei der Bauweise des Infrarot-Lötofens nach Anspruch 3 ist wesentlich, daß die Folie zu den den Heizraum begrenzenden Wänden zumindest einen Spalt frei läßt, durch den der vertikale Luftstrom zur Abführung der Lötdünste ohne zu großen Strömungswiderstand geführt werden kann.

Weiterhin ist bei der Dimensionierung der Folie darauf zu achten, daß die Ränder der auf sie aufgelegten bestückten Leiterplatten einen genügenden Abstand zu den Folienrändern haben, mit anderen Worten, die durch die Folie gebildete Luftsperre die aufgelegten Leiterplatten seitlich vollständig überragt. Bei der Ausbildung des Infrarot-Lötofens nach Anspruch 3, insbesondere als Durchlaufofen, ist diese Forderung im Hinblick auf die Längserstreckung des Trägers in Umlaufrichtung praktisch ohne weiteres erfüllt, während quer zur Umlaufrichtung die Dimensionierung des Trägers durch die Konstruktion des Infrarot-Lötofens festliegt und nur insoweit eine Begrenzung der Abmessungen der aufgelegten bestückten Leiterplatten zu beachten bleibt.

Die Verwendung eines Folienzuschnitts als flache Auflage der bestückten Leiterplatten vervollkommnet besonders den Infrarot-Lötofen in der Bauweise nach Anspruch 4, bei welchem der Träger als Schieblade nur zum Einführen der bestückten Leiterplatten in den Infrarot-Lötofen in diesen einschiebbar und zum Kühlen und Entnehmen der Leiterplatten mit den aufgelöteten Bauelementen aus diesem herausschiebbar ist.

Bei der letztgenannten Bauweise kann die Luftsperre alternativ als Schale aus einem Kunststoff geformt sein, der für Infrarot-Strahlung mittlerer Infrarot-Wellenlänge durchlässig ist. Die Schale hat den Vorteil, daß die eingelegte bestückte Leiterplatte mit Sicherheit eine zulässige Lage auf dieser Luftsperre einnimmt, die auch durch Betätigung einer als Träger ausgebildeten Schieblade im ungünstigsten Fall nicht beeinträchtigt werden kann. Der Abstand zu dem vertikalen Luftstrom wird durch den sich im wesentlichen vertikal erstreckenden Rand der Schale gewährleistet.- In den Ansprüchen 5 und 6 ist hingegen angegeben, wie bei der Bauweise des Infrarot-Lötofens als Durchlaufofen mit verschiedenen umlaufenden Trägern die vorzugsweise aus Polyimid - bestehende Folie mit den genannten physikalischen Eigenschaften zweckmäßig eingesetzt wird. Es hat sich herausgestellt, daß die Kombination der Polyimidfolie als flache Auflage der Leiterplatten in Verbindung mit Infrarot-Flächenstrahlern, die durch diese Auflage hindurchstrahlen, besonders günstig ist, wenn mittelwellige Infrarot-Strahler eingesetzt werden, die unter der Typenbezeichnung FS 400 der Firma Thermal Quarz-Schmelze GmbH angeboten werden.

Zur Durchführung des Aufschmelzlötens in einer Schutzgasatmosphäre, insbesondere Stickstoff, ist der Infrarot-Lötofen gemäß einem weiteren erfinderischen Aspekt nach den Ansprüchen 10 - 16 weitergebildet. Die Gemeinsamkeit der Ausführungsformen nach den Figuren 10 und 16 besteht darin, den Stickstoffverbrauch zu minimieren und gleichwohl für einen möglichst vollständigen Einschluß der zu lötenden Leiterplatten in Schutzgas während des Lötvorgangs zu sorgen. Während des Lötens in Schutzgasatmosphäre wird dieses Gas im wesentlichen nicht abgesaugt, was nicht ausschließt, daß unter einem geringen Überdruck in einer zu besprechenden Kammer stehendes Schutzgas aus dieser mit einem Teil der sich während der Aufheizphase und Schmelzphase bildenden Gase und Dämpfe aus der Kammer entweichen kann. Kühleinrichtungen des Infrarot-Lötofens können jedoch vorteilhaft verwendet werden, wenn der Lötvorgang abgeschlossen ist, wobei auch das Schutzgas aus der Kammer entfernt werden kann.

Im einzelnen ist zur Minimierung des Schutzgasverbrauchs unter Gewährleistung der Schutzgasatmosphäre während der kritischen Phasen des Lötvorgangs und bei möglichst effektiver Einwirkung der Infrarot-Strahlung nach Anspruch 10 vorgesehen, daß zur Aufnahme eines Schutzgases, insbesondere Stickstoff, über der für den Luftstrom undurchlässigen, jedoch für Infrarot-Strahlung durchlässigen Folie eine Kammer aus gasundurchlässigem Material ange ordnet ist, von der zumindest eine Oberseite für InfrarotStrahlung durchlässig ist.

Die Kammer bildet also in dem Infrarot-Lötofen unter Einschluß der als Träger vorgesehenen Folie ein kleines annähernd dichtes Teilvolumen zur Aufnahme des Stickstoffs, in dem die einzelnen Phasen des Aufschmelzlötens ablaufen. Dadurch daß die Oberseite der Kammer für Infrarot-Strahlung durchlässig ist, kann die oben besprochene Grundstruktur des Infrarot-Lötofens bei guter Wirksamkeit der Infrarot-Strahlung beibehalten werden. Es genügen also unkompliziert zu fertigende Abwandlungen zur Erweiterung des Infrarot-Lötofens auf einen Betrieb mit Schutzgasatmosphäre.

Besonders zweckmäßig wird ein Boden der Kammer nach Anspruch 11 durch die für den Luftstrom undurchlässige, jedoch für Infrarot-Strahlung durchlässige Folie gebildet, die auch dann vorgesehen war, wenn ein gleichmäßiges Aufschmelzlöten über die Gesamtflächen der Leiterplatten ohne Schutzgasatmosphäre durchgeführt werden soll. Durch den Einschluß dieser Folie in die Kammer für das Schutzgas entfällt ein zusätzlicher Boden, der sonst die Intensität der in die Kammer von unten dringenden Infrarot-Strahlung herabsetzen könnte.

Besonders vorteilhaft besteht die Oberseite der Kammer nach Anspruch 12 ebenfalls aus einer Folie, die in einem Rahmen gehalten ist. - Mit einer solchen Folie, die infolge der Halterung dünn gewählt werden kann, läßt sich die Infrarot-Strahlungsabsorption minimieren, so daß auch von oben eine wirksame Aufheizung der mit der Lotpaste versehenen Leiterplatten in der Kammer erfolgen kann.

Weiterhin ist zweckmäßig nach Anspruch 13 vorgesehen, daß auch die Seitenteile der Kammer aus in dem Rahmen gehaltenen Folienabschnitten bestehen. - Damit läßt sich auch die Streustrahlung der Infrarot-Strahler in dem Innern des Infrarot-Lötofens wirksam für einen raschen und gleichmäßigen Aufschmelzvorgang nutzen.

Der Rahmen kann nach Anspruch 14 aus Metall bestehen, es läßt sich jedoch ein anderer fester Werkstoff, der nicht wärmeempfindlich ist, für den Aufbau des Rahmens verwenden.

Alternativ kann nach Anspruch 15 eine Grundstruktur der Kammer einschließlich der Seitenflächen aus einem festen, für Infrarot-Strahlung durchlässigen Kunststoff gebildet sein. - Eine solche Grundstruktur aus festem Kunststoff läßt sich in größeren Serien besonders fertigungskünstig herstellen, insbesondere da ein separater Rahmen und ein Einspannen von Folienabschnitten in diesen Rahmen entfallen. Die Grundstruktur der Kammer kann insbesondere nach Anspruch 16 vorteilhaft so erzeugt werden, daß die Oberseite und Seitenteile der Kammer durch ein im Querschnitt U-förmiges selbsttragendes, gebogenes Kunststoffteil gebildet werden.

Besonders vorteilhaft ist die Oberseite der Kammer nach Anspruch 16 hochklappbar. - Damit kann die Kammer auf dem Träger in dem Infrarot-Lötofen beispielsweise in einer Schieblade fixiert werden, gleichwohl können die bestückten Leiterplatten leicht eingelegt und nach Abschluß des Aufschmelzlötvorgangs entnommen werden. Die Lage der Kammer ist während der aktiven Phasen des Aufschmelzlötens bezüglich der Infrarot-Strahler definiert.

Besonders zweckmäßig besteht die Folie und die gegebenenfalls die Kammer - teilweise - bildenden Kunststoffteile aus Polyimid, das insbesondere unter dem Warenzeichen "Kapton" bekannt ist, da dieser Kunststoff Infrarot-Strahlung weitgehend durchläßt, d.h. nur wenig absorbiert.

Bei einer Ausführungsform der Infrarotkammer mit einem durch Wände begrenzten Abluftschacht, in dem ein Träger von Leiterplatten insbesondere als Schieblade angeordnet ist, wird die Kammer besonders vorteilhaft nach Anspruch 19 durch eine oberhalb des Trägers eben und waagerecht angeordnete Folie gebildet, die bis an die Wände des Abluftschachts heranreicht und mit einer Klappvorrichtung versehen ist. - Hier bilden also die Wände des Abluftschachts Teile der Kammer und können insbesondere die Klappvorrichtung halten. Die Klappvorrichtung besteht in einer einfachen Ausführungsform aus einem Scharnier, an dem ein die Folie haltender Rahmen gelagert ist, und einer Auflage des Rahmens an der zu dem Scharnier entgegengesetzten Seite.

Ausführungsbeispiele der Erfindung, die sich auf eine Bauweise des Infrarot-Lötofens mit einem als Schieblade ausgebildeten Träger beziehen, werden im folgenden anhand einer Zeichnung mit vier Figuren erläutert. Es zeigen:

Fig. 1 einen Schnitt durch den Infrarot-Lötofen von der Seite gesehen mit einer ersten Ausführungsform einer Kammer für Schutzgas,

Fig. 2 einen Schnitt durch den Infrarot-Lötofen von vorne gesehen entlang der Schnittlinie A-A in Fig. 1, jedoch mit einer zweiten Ausführungsform einer Kammer für Schutzgas,

Fig. 3 eine Seitenansicht auf die Schieblade und die Luftsperre ohne Kammer bildende Elemente und

Fig. 4 die Schieblade und die Luftsperre in einer Draufsicht ebenfalls ohne Kammer bildende Elemente.

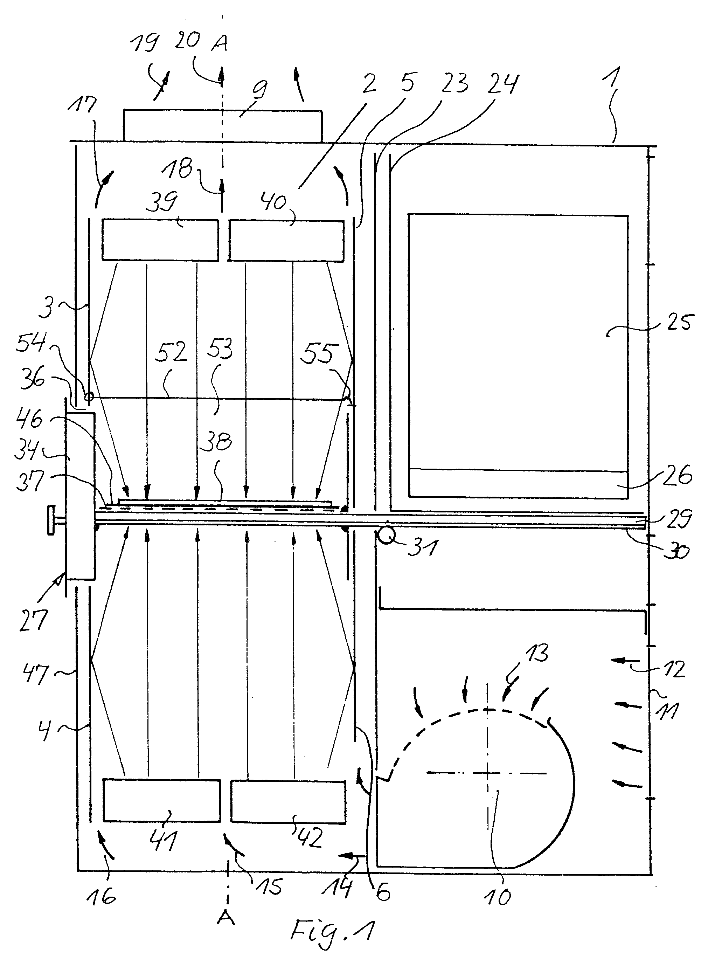

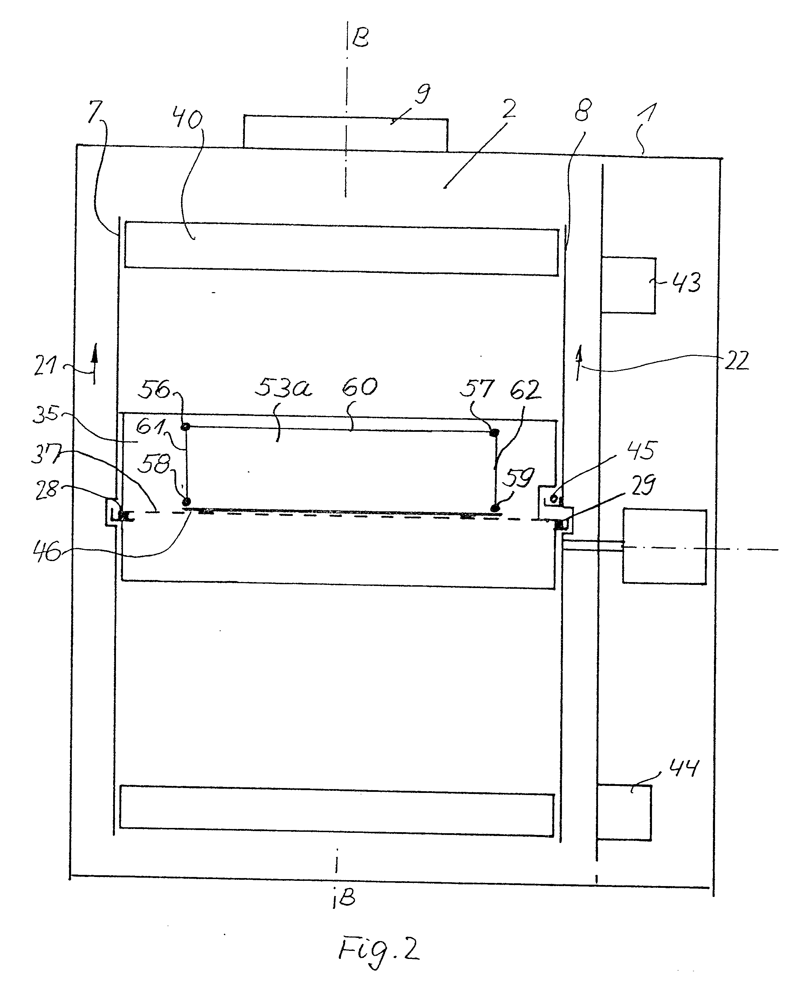

Gemäß den Figuren 1 und 2 wird in einem Gehäuse 1 des Infrarot-Lötofens ein inneres Gehäuse durch die Wände 3 - 8 seitlich begrenzt. Das innere Gehäuse stellt einen Abluftschacht dar, der in einen oberen Stutzen 9 zum Abzug der Abluft übergeht. Der Abluftschacht wird durch einen Querstromlüfter 10, der Luft aus der in der Zeichnung im einzelnen nicht dargestellten Öffnung 11 ansaugt, zwangsbelüftet. Einige der Pfeile, welche die Luftströmung darstellen, sind mit 12 - 22 bezeichnet. Aus Fig. 2 ist insbesondere ersichtlich, daß die Luftströmung nicht nur innerhalb des inneren Gehäuses verläuft, sondern auch außerhalb dieses Gehäuses, siehe Pfeile 21 und 22. Die Zwangsbelüftung durch den Querstromlüfter 10 wird durch die Kaminwirkung in dem inneren Gehäuse unterstützt. Die Luftströmung zwischen dem inneren und dem äußeren Gehäuse bildet im wesentlichen die Wärmeisolierung nach außen.

Gemäß Fig. 1 sind weiterhin Wärmeleitflächen 23, 24 vorgesehen, welche das innere Gehäuse zusätzlich gegenüber einer Temperaturregeleinrichtung 25 und Elektromotor-Steuereinrichtung 26 thermisch abschotten.

In dem Gehäuse ist eine allgemein mit 27 bezeichnete Schieblade verschiebbar gelagert. Hierzu umfaßt die Schieblade zwei Schienen 28 und 29, zwischen denen eine Antriebsstange 30 in fester Verbindung mit der Schieblade steht. Die Antriebsstange steht über ein Reibrad 31 und eine Andruckrolle 32 mit einem Elektromotor 33 in Verbindung. Die Schieblade weist eine vordere doppelwandige Schiebladenwand 34 auf, die wärmeisolierend wirkt, sowie eine hintere Schiebladenwand 35, die als Verschlußblech an der Öffnung 36 dient, wenn die Schieblade herausgezogen ist. Zwischen der vorderen Schiebladenwand 34 und der hinteren Schiebladenwand 35 erstreckt sich ein Gitter 37.

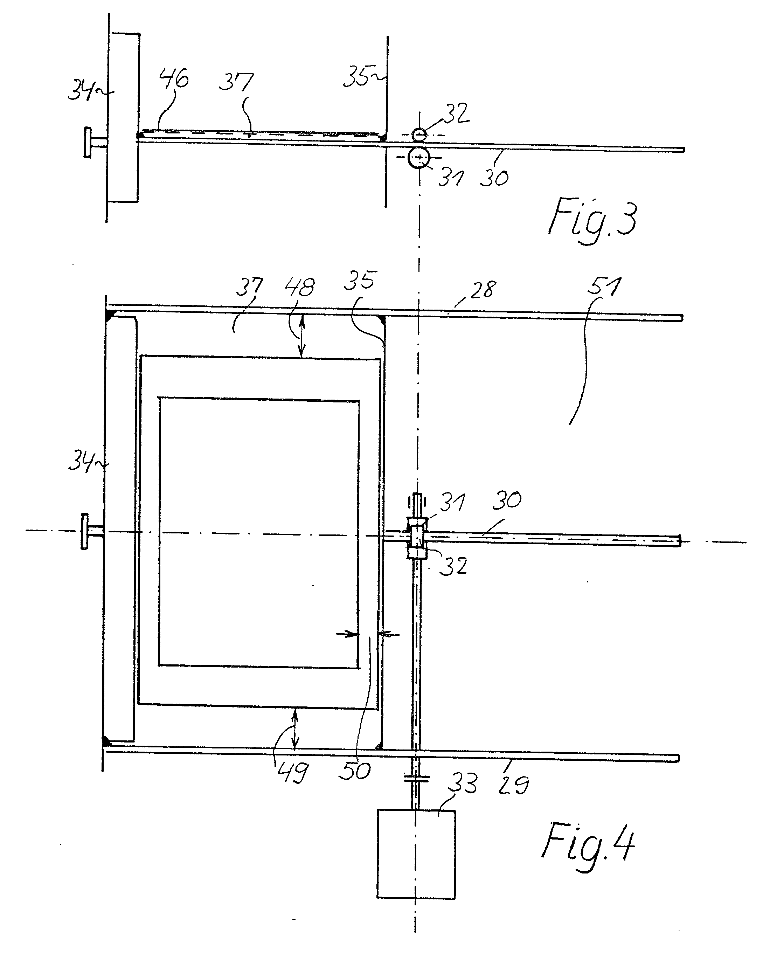

Das Gitter 37 hat eine Stützfunktion für eine Leiterplatte 38 und eine flache Luftsperre 46, die hier als Zuschnitt einer Folie aus reinem Polyimid ausgebildet ist. Dieser Zuschnitt 46 ist auf dem Gitter 37 befestigt. Er ist in sämtlichen Figuren gezeigt, während die Leiterplatte 38 nur in den Figuren 1 und 4 dargestellt ist. Die Luftsperre 46 bzw. der Zuschnitt der Folie bedeckt, wie insbesondere aus Fig. 4 zu sehen ist, die Fläche des Gitters 37 überwiegend, jedoch nicht vollständig. Insbesondere bleiben zwischen je einer Schiene 28, 29 bzw. der zugehörigen Wand 7 bzw. 8 - siehe auch Fig. 2 - und dem Zuschnitt Spalte mit den Spaltbreiten 48, 49 frei, durch welche ein vertikaler Luftstrom fließen kann, wie auch in dem freien Raum 51 hinter der Schieblade. Somit wird die Abführung von Lötdünsten durch einen vertikalen Luftstrom während des Aufheizens und Schmelzens gewährleistet. Im Anschluß hieran kann in der Abkühlphase, wenn die Schieblade herausgezogen ist, der vertikale Luftstrom in dem Abluftschacht 2 praktisch ungehindert fließen.

Der Abluftschacht 2 kann auch als Heizkammer infolge der Anordnung der Infrarot-Flächenstrahler 39 - 42 bezeichnet werden, der weiter unten beschrieben ist.

Hinsichtlich der Luftsperre 46 kann aus Fig. 4 weiterhin ersehen werden, wie zwischen der größten vorgesehenen Leiterplatte 38 und dem nicht bezeichneten Außenrand der Luftsperre 46 Mindestabstände z.B 50 verbleiben sollen, damit die Luftsperre die gewünschte Wirkung entfalten kann, d.h. den Einfluß der vertikalen Luftströmung auf die Leiterplatte 38 in der Weise verringert, daß die Leiterplatte über ihre gesamte Fläche praktisch eine gleichmäßige Temperatur annimmt, während örtliche Temperaturgradienten im wesentlichen nur außerhalb der in Fig. 4 sichtbaren Grundfläche der Leiterplatte im Bereich des Zwischenraums zu dem Außenrand der Luftsperre mit dem Mindestabstand 50 auftreten dürfen.

Zu den Spaltbreiten 48 und 49 wird darauf hingewiesen, daß diese bei der dargestellten Bauweise des Infrarot-Lötofens minimal sein können, woraus sich eine sehr gute Nutzung der Oberfläche des Gitters 37 ergibt, da während des Aufheizens und Schmelzens nur die Lötdünste abzuführen sind, während die Kühlung, wie erwähnt, bei herausgezogener Schieblade durch die Luftsperre ungehindert erfolgen kann.

Aus den Figuren 1 und 2 kann entnommen werden, wie parallel zu dem Gitter 37 und der Luftsperre 46 und im Abstand zu diesen oben und unten Infrarot-Flächenstrahler 39 - 42 angeordnet sind. Der Abstand der Flächenstrahler 39 - 42 zu dem der Luftsperre 46 beträgt dabei wenigstens 150 mm. Die Luftsperre hat nur eine geringe Dicke von 20 bis 135 µm und absorbiert deswegen und wegen der Eigenschaften des Polyimids kaum die Infrarot-Strahlung der unteren InfrarotStrahler 41, 42. Diese sind mittelwellige Infrarot-Flächenstrahler einer geringen Wärmeträgheit. - Aus Fig. 2 sind noch Anschlußkästen für die Infrarot-Strahler ersichtlich, die mit 43 und 44 bezeichnet sind. Aus Fig. 2 kann ferner entnommen werden, wie im einzelnen ein Temperaturfühler 45 in der Nähe der Auflagefläche 37 angeordnet ist, so daß die von den Infrarot-Strahlern in diesem Flächenbereich hervorgerufene Temperatur erfaßt, mit der Temperaturregeleinrichtung 25 zur Erzeugung eines vorgegebenen Heizprofils zeitgesteuert geregelt werden kann. Wegen der Infrarot-Strahler in dem Abluftschacht 2 kann dieser auch als Heizraum bezeichnet werden.

Durch Betätigen einer nicht dargestellten Starttaste wird der zeitliche Ablauf eines Heizprofils einschließlich einer anschließenden Abkühlphase initiiert. Zuvor wird die Schieblade 27 vorzugsweise durch den Elektromotor 33 herausgefahren, damit die Auflagefläche mit den bestückten Substraten bzw. Leiterplatten belegt werden kann. Nach automatischem Einzug der Schieblade - die auch manuell erfolgen kann - werden die Infrarot-Strahler 39 - 42 mit Strömen zur Erzeugung des gewünschten Heizprofils beaufschlagt. Die Ableitung der Lötdünste erfolgt durch den Querstromlüfter 10 bei gleichmäßiger Erwärmung der Leiterplatte 38. Der Querstromlüfter bleibt eingeschaltet, wenn in der Abkühlphase die Infrarot-Strahler abgeschaltet sind. Anschließend wird die Schieblade 27 vorzugsweise wiederum mit Hilfe des Elektromotors 33 aus dem Gehäuse 1 herausgeschoben, so daß die Leiterplatte mit den aufgelöteten Bauelementen gegebenenfalls nach weiterer vorangehender Abkühlung außerhalb des Gehäuses 1 bequem entnommen werden können.

Mit der zeitgesteuerten Temperaturregeleinrichtung 25 kann insbesondere ein solches örtlich gleichmäßiges Heizprofil auf der Leiterplatte erzeugt werden, daß zum Vortrocknen während etwa einer Minute 80° C erreicht werden, daran anschließend bis etwa 150° C während einer Minute erreicht werden und schließlich während einer Lötphase von etwa 4,5 sek. 220° C auftreten, woran anschließend abgekühlt wird.

Im folgenden werden anhand der Figuren 1 und 2 die speziellen Einrichtungen des Infrarot-Lötofens besprochen, wenn dieser zum Aufschmelzlöten in einer Schutzgasatmosphäre, insbesondere Stickstoffgas, verwendet werden soll:

In Fig. 1 ist mit 52 eine in einem Rahmen gehaltene Folie aus Polyimid bezeichnet, welche eine Oberseite einer Kammer 53 bildet, in welche Stickstoffgas durch eine nicht dargestellte Zuführung unter leichtem Überdruck eingeleitet werden kann. Der rechteckförmige Rahmen mit Folie erstreckt sich zwischen den Wänden 3 und 5, die sonst zur Begrenzung des Abluftschachts 2 vorgesehen sind, sowie quer dazu bis zu in Fig. 1 nicht dargestellten Seitenflächen der Kammer. Die Seitenflächen können durch die Wände 7 und 8 gebildet werden, siehe Fig. 2. Ein Boden der Kammer wird durch den Zuschnitt 46 der Folie aus reinem Polyimid gebildet, der auf dem Gitter 37 aufliegt. Der Zuschnitt deckt dabei zur Schutzgaslötung zweckmäßig das Gitter 37 weitgehend ab, um ein möglichst geschlossenes Volumen zur Aufnahme des Schutzgases in der Kammer zu bilden.

Aus Fig. 1 kann weiter ersehen werden, daß die in dem Rahmen gehaltene Folie 2 an der nach vorne gerichteten Wand 3 mittels eines angedeuteten Scharniers 54 gelagert ist und an einer entgegengesetzten, inneren Seite des Infrarot-Lötofens an einer Auflagestelle 55 aufliegt. Diese Lagerung des Rahmens ist insofern zweckmäßig, als durch ein Gleitelement, welches beispielsweise an der hinteren Seite der Schieblade an der Schiebladenwand 35 angebracht sein kann, dieser selbsttätig nach oben geöffnet wird, wenn die Schieblade herausgezogen wird. Damit kann das Schutzgas aus der Kammer zumindest zum Teil entweichen, bevor die Schieblade aus dem Infrarot-Lötofen herausgezogen wird. Weiterhin kann entweichendes Schutzgas mit den Gasen oder Dämpfen, die sich während des Lötvorgangs gebildet haben, bei herausgezogener Schieblade durch eine getrennte Saugvorrichtung zweckmäßig mit einer Haube in der Art einer Küchendunsthaube - abgesaugt werden, um eine Umweltbelästigung auszuschließen.

In der Ausführungsform der Kammer 53a nach Fig. 2 wird deren Boden ebenfalls durch den Zuschnitt 46 der Folie gebildet, welche fest auf dem Gitter 37 aufliegt. Ein übriger wesentlicher Teil der Kammer wird durch einen Rahmen, dessen Streben bei 56 - 59 angedeutet sind und der als Oberseite ebenfalls einen Folienzuschnitt 60, günstig aus reinem Polyimid sowie weitere Folienzuschnitte 61 und 62 als Seitenflächen aufweist, komplettiert. Es ist vorgesehen, daß hier das Oberteil, gebildet aus dem Rahmen mit den Streben 56 und 59 sowie den Folienzuschnitten 60 - 62, in seiner Gesamtheit von dem Träger 37 und dem Zuschnitt 46 abgehoben werden kann. Die mit den Bauelementen zu verlötenden Leiterplatten können bei herausgezogener Schieblade und entnommenem Oberteil der Kammer 53a bequem auf den Träger und den Folienzuschnitt 46 aufgelegt werden und nach Durchführung der Aufschmelzlötung ungehindert von dem Träger entfernt werden. Die selbständige Ausbildung des Kammeroberteils gemäß Fig. 2 hat den Vorteil, daß das Kammervolumen weiterhin optimiert werden kann, da die Seitenflächen 61 und 62 nicht bis an die Wände 7 und 8 heranzureichen brauchen.

**Patentansprüche**

1. Infrarot-Lötofen zum Aufschmelzlöten (Reflowlöten) von elektronischen Bauelementen auf Leiterplatten mittels einer Lotpaste, mit einem Heizraum, der mit einem im wesentlichen vertikalen Luftstrom belüftet ist und in dem die Leiterplatten auf einem für Infrarot-Strahlung und für den Luftstrom zumindest teilweise durchlässigen Träger aufliegen, über und unter welchem Träger Infrarot-Strahler angeordnet sind, welche die mit den Bauelementen bestückten und mit der Lotpaste versehenen Leiterplatten während einer Aufheizphase und einer Schmelzphase mit unterschiedlichen Temperaturen beheizen, **dadurch gekennzeichnet,** daß der für die Infrarot-Strahlung durchlässige Träger (34, 35, 37) eine für den Luftstrom undurchlässige, jedoch für die Infrarot-Strahlung durchlässige flache Luftsperre (46) als Auflage der Leiterplatten (z.B 38) aufweist, daß die Luftsperre (46) die aufgelegten Leiterplatten seitlich vollständig überragt, jedoch im Abstand (48, 49) gegenüber den Heizraum begrenzenden Wänden (7, 8) angeordnet ist und damit mindestens einen Spalt (Spaltbreiten 48, 49) für den vertikalen Luftstrom begrenzt.

2. Infrarot-Lötofen nach Anspruch 1, **dadurch gekennzeichnet,** daß der Träger im wesentlichen aus einem Gitter (37) besteht und daß auf dem Gitter ein Zuschnitt einer hitzebeständigen, für Infrarot-Strahlung mittlerer Infrarot-Wellenlänge durchlässigen Folie als Luftsperre (46) angebracht ist.

3. Infrarot-Lötofen zum Aufschmelzlöten von elektronischen Bauelementen auf Leiterplatten mittels einer Lotpaste, mit einem Heizraum, der mit einem im wesentlichen vertikalen Luftstrom belüftet ist und in dem die Leiterplatten auf einem für den Luftstrom undurchlässigen Träger aufliegen, über und unter welchem Träger Infrarot-Strahler angeordnet sind, welche die mit den Bauelementen bestückten und mit Lotpaste versehenen Leiterplatten während einer Aufheizphase und einer Schmelzphase beheizen, **dadurch gekennzeichnet,** daß der Träger im wesentlichen nur aus einer hitzebeständigen, für Infrarot-Strahlung mittlerer Infrarot-Wellenlänge durchlässigen Folie besteht, die dergestalt im Abstand zu den Heizraum begrenzenden Wänden angeordnet ist, daß sie mindestens einen Spalt für den vertikalen Luftstrom begrenzt.

4. Infrarot-Lötofen nach Anspruch 2 oder 3, **dadurch gekennzeichnet,** daß der Träger als Schieblade nur zum Einführen der bestückten Leiterplatten (z.B 38) in den Infrarot-Lötofen in diesen einschiebbar und zum Kühlen und Entnehmen der Leiterplatten mit den aufgelöteten Bauelementen aus diesem herausschiebbar ist.

5. Infrarot-Lötofen als Durchlaufofen nach Anspruch 2, **dadurch gekennzeichnet,** daß der Träger als umlaufendes Gitter ausgebildet ist, auf dessen mittlerem Bereich die Folie befestigt ist, die sich außen um das umlaufende Gitter erstreckt.

6. Infrarot-Lötofen als Durchlaufofen nach Anspruch 3, **dadurch gekennzeichnet,** daß die Folie als Endlosband ausgebildet ist und den umlaufenden Träger selbst bildet.

7. Infrarot-Lötofen nach einem der vorangehenden Ansprüche, **dadurch gekennzeichnet,** daß die Folie aus Polyimid besteht.

8. Infrarot-Lötofen nach einem der vorangehenden Ansprüche, **dadurch gekennzeichnet,** daß die Folie eine Dicke von 20 - 135 µm aufweist.

9. Infrarot-Lötofen nach Anspruch 1, **dadurch gekennzeichnet,** daß die Luftsperre als Schale aus einem Kunststoff geformt ist, der für Infrarot-Strahlung mittlerer Infrarot-Wellenlänge durchlässig ist.

10. Infrarot-Lötofen nach einem der vorangehenden Ansprüche, **dadurch gekennzeichnet,** daß zur Aufnahme eines Schutzgases, insbesondere Stickstoff, über der für den Luftstrom undurchlässigen, jedoch für Infrarot-Strahlung durchlässigen Folie (46) eine Kammer (53, 53a) aus gasundurchlässigem Material angeordnet ist, von der zumindest eine Oberseite (Folie 52, 60) für Infrarot-Strahlung durchlässig ist.

11. Infrarot-Lötofen nach Anspruch 10, **dadurch gekennzeichnet,** daß ein Boden der Kammer durch die für den Luftstrom undurchlässige, jedoch für Infrarot-Strahlung durchlässige Folie (46) gebildet wird.

12. Infrarot-Lötofen nach Anspruch 1 oder 2, **dadurch gekennzeichnet,** daß die Oberseite der Kammer (53a) aus einer Folie (60) besteht, die in einem Rahmen (56 - 59) gehalten ist.

13. Infrarot-Lötofen nach Anspruch 12, **dadurch gekennzeichnet,** daß auch die Seitenteile der Kammer (53a) aus in dem Rahmen (56 - 59) gehaltenen Folienabschnitten bestehen.

14. Infrarot-Lötofen nach Anspruch 12 oder 13, **dadurch gekennzeichnet,** daß der Rahmen (56 - 59) aus Metall besteht.

15. Infrarot-Lötofen nach einem der Ansprüche 10 - 13, **dadurch gekennzeichnet,** daß eine Grundstruktur der Kammer einschließlich der Seitenflächen aus einem festen, für Infrarot-Strahlung durchlässigen Kunststoff gebildet ist.

16. Infrarot-Lötofen nach Anspruch 10 oder 11, **dadurch gekennzeichnet,** daß zumindest die Oberseite und Seitenteile der Kammer durch ein im Querschnitt U-förmiges, selbsttragendes, gebogenes Kunststoffteil gebildet werden.

17. Infrarot-Lötofen nach einem der Ansprüche 10 - 15, **dadurch gekennzeichnet,** daß die Oberseite (Folie 52) der Kammer (53) hochklappbar ist.

18. Infrarot-Lötofen nach einem der vorangehenden Ansprüche, **dadurch gekennzeichnet,** daß die Folie (52, 60) und gegebenenfalls das Kunststoffteil aus Polyimid besteht.

19. Infrarot-Lötofen mit einem durch Wände begrenzten Abluftschacht, in dem ein Träger von Leiterplatten insbesondere als Schieblade angeordnet ist, nach Anspruch 10, **dadurch gekennzeichnet,** daß die Kammer durch eine oberhalb des Trägers (37) eben und waagerecht angeordnete Folie (52) gebildet wird, die bis an die Wände (3, 5) des Abluftschachts (2) heranreicht und mit einer Klappvorrichtung (54, 55) versehen ist.

Fig.1

Fig.2

Fig.3

Fig.4

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| | **EINSCHLÄGIGE DOKUMENTE** | | EP 89 71 0007 |
| A | WO - A1 - 85/03 248 (VITRONICS) <br> * Zusammenfassung; Fig. 2 * <br> -- | 1-19 | H 05 K 3/34 |
| A | EP - B1 - 0 104 565 (NORTHERN TELE-COM) <br> * Zusammenfassung; Patentansprüche 1-4 * <br> -- | 1-19 | |
| A | EP - A2 - 0 209 650 (VANZETTI) <br> * Zusammenfassung; Fig. 3 * <br> -- | 1-19 | |
| A | EP - A2 - 0 251 257 (LICENTIA) <br> * Zusammenfassung; Fig. 1,2 * <br> -- | 1-19 | |
| A,P | US - A - 4 792 302 (BAKER) <br> * Zusammenfassung; Fig. 1 * <br> -- | 1-19 | RECHERCHIERTE SACHGEBIETE (Int. Cl.4) |
| A,P | EP - A2 - 0 279 604 (HOLLIS) <br> * Zusammenfassung; Fig. 1 * <br> -- | 1-19 | H 05 K 3/00 <br> H 05 K 13/00 <br> B 23 K 1/00 <br> F 27 B 9/00 |
| D,P. A | DE - A1 - 3 715 940 (HIMMELREICH) <br> * Zusammenfassung; Fig. 1-3 * <br> -- | 1-19 | |
| D,A | PROSPEKT DER FA. DEMETRON "Lot-pasten" Seiten 1-15 <br> ---- | 1-19 | |

Der vorliegende Recherchenbericht wurde für alle Patentansprüche erstellt.

| Recherchenort | Abschlußdatum der Recherche | Prüfer |
|---|---|---|
| WIEN | 23-05-1989 | VAKIL |